# EUROPEAN PATENT APPLICATION

(11) **EP 4 586 760 A1**
(43) Date of publication of application: **16.07.2025**
(21) Application number: 24215085.2
(22) Date of filing: 25.11.2024
(51) Int. Cl.: H10B 63/00, H10N 70/20

(54) **VARIABLE RESISTANCE MEMORY DEVICE**

(30) Priority: 15.01.2024 KR 20240006308
(71) Applicant: Samsung Electronics Co., Ltd., Suwon-si, Gyeonggi-do 16677 (KR)
(72) Inventor: PARK, Garam, 16678 Suwon-si (KR); KIM, Yumin, 16678 Suwon-si (KR); SONG, Hyunjae, 16678 Suwon-si (KR); YANG, Seungyeul, 16678 Suwon-si (KR); HYUN, Seungdam, 16678 Suwon-si (KR)
(74) Representative: Elkington and Fife LLP

(57) **Abstract**

Disclosed is a variable resistance memory device (100) including a resistance change layer (129) having resistance characteristics that change according to an applied voltage, a transistor channel layer (125) provided on the resistance change layer, and a gate electrode (121), preferably with a gate insulating layer (123), provided on the channel layer. The resistance change layer includes metal nitride or oxynitride, preferably TaN or TaON. Multiple memory cells (MC) may be stacked to form a vertical NAND cell string (CS).

## Description

### FIELD OF THE INVENTION

Apparatuses and methods consistent with example embodiments relate to a variable resistance memory device and an electronic apparatus including the same.

### BACKGROUND OF THE INVENTION

Non-volatile memory devices include a plurality of memory cells which retain information even when the power supply is turned off and thus the stored information can be used again when power is turned on. These non-volatile memory devices are widely applicable to mobile phones, digital cameras, personal digital assistants (PDAs), portable computer devices, etc.

Recently, as memory devices with high integration and low power are required, vertical NAND (VNAND) flash memory devices have been developed, and as integration increases, vertical NAND flash memory devices including resistance change materials have been researched in order to overcome the limitations of vertical NAND flash memory devices with charge trap layers.

### SUMMARY OF THE INVENTION

One or more example embodiments provide a variable resistance memory device and an electronic apparatus including the same.

According to an aspect of the disclosure, a variable resistance memory device may include: a resistance change layer having resistance characteristics that change according to a voltage applied to the resistance change layer; a channel layer provided on the resistance change layer; and a gate electrode provided on the channel layer, wherein the resistance change layer may include metal nitride or metal oxynitride.

A ratio of nitrogen content to a sum of nitrogen content and oxygen content in the resistance change layer may be in a range from 0.01 to 1.

The ratio of nitrogen content to the sum of nitrogen content and oxygen content in the resistance change layer is less than or equal to 0.9.

The resistance change layer may include tantalum nitride (TaN) or tantalum oxynitride (TaON).

The metal may include a transition metal, aluminum (Al), or gallium (Ga).

The channel layer may include silicon (Si), germanium (Ge), silicon germanium (SiGe), a Group III-V semiconductor, an oxide semiconductor, a nitride semiconductor, an oxynitride semiconductor, a two-dimensional semiconductor material, quantum dots, or an organic semiconductor.

The gate electrode may include a metal material, metal nitride, silicon doped with impurities, or a two-dimensional conductive material.

The variable resistance memory device may further include a gate insulating layer provided between the gate electrode and the channel layer.

The gate insulating layer may further include silicon oxide, silicon nitride, or silicon oxynitride.

According to an aspect of the disclosure, a variable resistance memory device may include a plurality of cell strings, wherein each of the plurality of cell strings may extend vertically on a substrate and include: a channel layer; a resistance change layer provided inward relative to the channel layer, the resistance change layer having resistance characteristics that change according to a voltage applied to the resistance change layer; and a plurality of gate electrodes provided outward relative to the channel layer, wherein the resistance change layer may include metal nitride or metal oxynitride.

A ratio of nitrogen content to a sum of nitrogen content and oxygen content in the resistance change layer may be in a range from 0.01 to 1.

The ratio of nitrogen content to the sum of nitrogen content and oxygen content in the resistance change layer may be less than or equal to 0.9.

The resistance change layer may include tantalum nitride (TaN) or tantalum oxynitride (TaON).

The metal may include a transition metal, aluminum (Al), or gallium (Ga).

A channel hole extending in a direction perpendicular to the substrate may be formed inward relative to the channel layer.

The channel layer and the resistance change layer may be each formed in a cylindrical shape surrounding the channel hole.

The plurality of gate electrodes may be arranged apart from each other in a direction perpendicular to the substrate, and the plurality of gate electrodes may surround the channel layer.

The variable resistance memory device may further include an interlayer insulating layer provided between the plurality of gate electrodes.

The variable resistance memory device may further include a gate insulating layer provided between the plurality of gate electrodes and the channel layer.

According to another aspect of the disclosure, a variable resistance memory device may include a cell string, wherein the cell string may include: a gate layer comprising a plurality of gate electrodes spaced apart from each other in an axial direction of the cell string; a plurality of inner layers provided inward from the gate layer towards a center of the cell string in a radial direction, wherein the plurality of inner layers may include: a resistance change layer with resistance that changes according to a voltage applied to the resistance change layer; and a channel layer provided between the resistance change layer and the gate layer in the radial direction. The resistance change layer may include metal nitride or metal oxynitride.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a perspective view schematically illustrating a variable resistance memory device according to one or more embodiments;
FIG. 2 illustrates a cross-section of a cell string illustrated in FIG. 1;
FIG. 3 is an enlarged view of portion A of a memory cell illustrated in FIG. 2;
FIG. 4 is an enlarged view of portion B of FIG. 2;
FIG. 5 shows simulation results obtained using Discrete Fourier Transform (DFT) with regard to oxygen vacancy (Vo) formation energy and nitrogen vacancy (Vn) formation energy for tantalum oxide (TaO), tantalum oxynitride (TaON), and tantalum nitride (TaN) resistance change layers;
FIG. 6 shows simulation results obtained using DFT with regard to a band gap according to a vacancy concentration for TaO, TaON, and TaN resistance change layers;
FIG. 7A shows a structure of a variable resistance memory device according to a comparative example;
FIG. 7B shows structure model of a variable resistance memory device according to one or more embodiments;
FIG. 8A shows results of measuring a TaO resistance change layer illustrated in FIG. 7A by using Transmission Electron Microscopy with Energy-Dispersive X-ray Spectroscopy (TEM EDS);
FIG. 8B shows results of measuring the TaON resistance change layer illustrated in FIG. 7A by using TEM EDS;
FIG. 9A shows I-V characteristics of the variable resistance memory device according to the comparative example illustrated in FIG. 7A;
FIG. 9B shows I-V characteristics of the variable resistance memory device according to the embodiment illustrated in FIG. 7B;
FIG. 10 illustrates an example of an equivalent circuit diagram of a variable resistance memory device according to the one or more embodiments illustrated in FIG. 1;
FIG. 11 illustrates a variable resistance memory device according to another embodiment;
FIG. 12 is a block diagram of a memory system according to one or more embodiments; and
FIG. 13 is a block diagram illustrating a neuromorphic apparatus and an external device connected thereto, according to one or more embodiments.

### DETAILED DESCRIPTION

Example embodiments are described in greater detail below with reference to the accompanying drawings.

In the following description, like drawing reference numerals are used for like elements, even in different drawings. The matters defined in the description, such as detailed construction and elements, are provided to assist in a comprehensive understanding of the example embodiments. However, it is apparent that the example embodiments can be practiced without those specifically defined matters. Also, well-known functions or constructions are not described in detail since they would obscure the description with unnecessary detail.

As used herein, the term "and/or" includes any and all combinations of one or more of the associated listed items. Expressions such as "at least one of," when preceding a list of elements, modify the entire list of elements and do not modify the individual elements of the list.

It will also be understood that when an element is referred to as being "on" or "above" another element, the element may be in direct contact with the other element or other intervening elements may be present. The singular forms include the plural forms unless the context clearly indicates otherwise. It should be understood that, when a part "comprises" or "includes" an element in the specification, unless otherwise defined, other elements are not excluded from the part and the part may further include other elements.

The use of the terms "a" and "an" and "the" and similar referents in the context of describing the disclosure are to be construed to cover both the singular and the plural. The steps of all methods described herein can be performed in any suitable order unless otherwise indicated herein or otherwise clearly contradicted by context.

While such terms as "first," "second," etc., may be used to describe various elements, such elements must not be limited to the above terms. The above terms may be used only to distinguish one element from another.

In addition, terms such as "... unit", "... module", or the like refer to units that perform at least one function or operation, and the units may be implemented as hardware or software or as a combination of hardware and software.

The connecting lines, or connectors illustrated in the various figures presented are intended to represent exemplary functional relationships and/or physical or logical couplings between the various elements. It should be noted that many alternative or additional functional relationships, physical connections or logical connections may be present in a practical device.

The use of any and all examples, or exemplary language provided herein, is intended merely to better illuminate the disclosure and does not pose a limitation on the scope of the disclosure unless otherwise claimed.

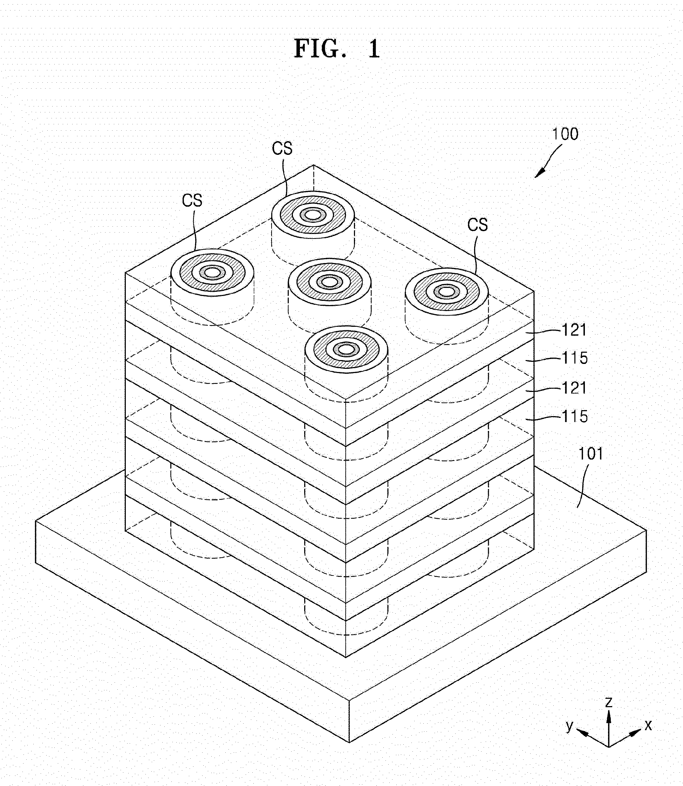

FIG. 1 is a perspective view schematically illustrating a variable resistance memory device 100 according to one or more embodiments. The variable resistance memory device 100 illustrated in FIG. 1 may be, for example, a vertical NAND flash memory device.

Referring to FIG. 1, the variable resistance memory device 100 may include a plurality of cell strings CS disposed on a substrate 101. Each cell string CS may be provided to extend in a direction (a z-axis direction in FIG. 1) perpendicular to a surface of the substrate 101 on which the plurality of cell strings CS are stacked. The z-axis direction may refer to an axial direction of a cell string. The plurality of cell strings CS may be arranged in various shapes on the substrate 101.

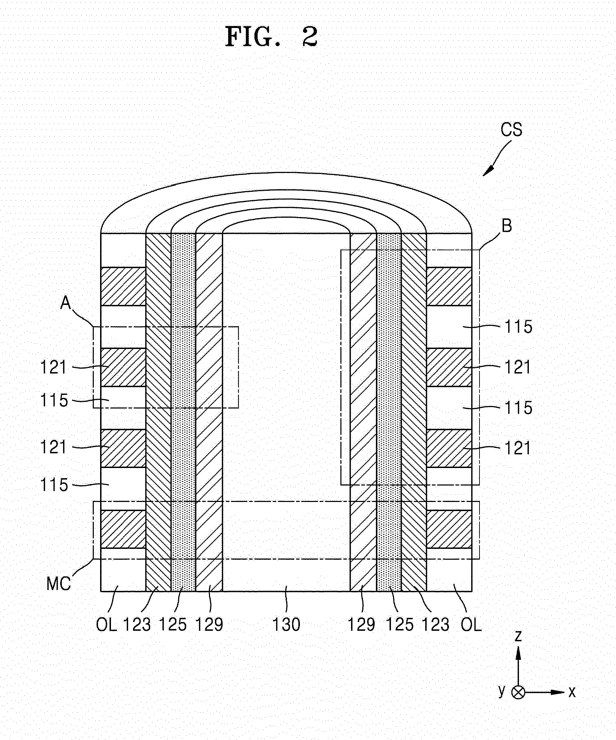

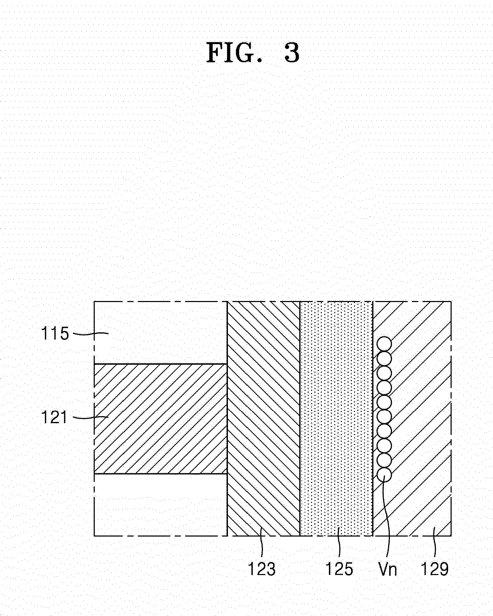

FIG. 2 illustrates a cross-section of the cell string CS illustrated in FIG. 1. FIG. 3 is an enlarged view of portion A of a memory cell MC illustrated in FIG. 2.

Referring to FIGS. 2 and 3, the cell string CS includes a plurality of memory cells MC stacked in the direction (i.e., the z-axis direction) perpendicular to the substrate 101. The substrate 101 may include various materials. For example, the substrate 101 may include, but is not limited to, a single crystal silicon substrate, a compound semiconductor substrate, or a silicon on insulator (SOI) substrate. Additionally, the substrate 101 may further include, for example, an impurity region by doping, a peripheral circuit that selects and controls electronic apparatuses such as transistors, or memory cells that store data.

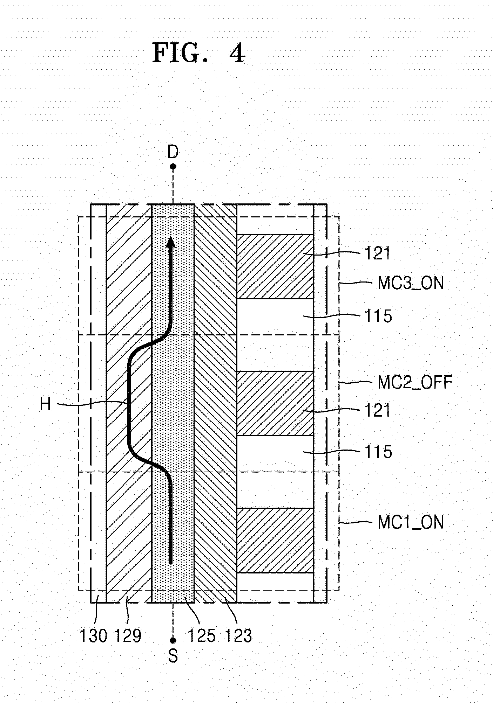

The cell string CS includes an outermost layer OL including a plurality of gate electrodes 121 stacked and spaced apart from each other in the axial direction. The outermost layer OL may be also referred to as a gate layer. The cell string CS further includes a gate insulating layer 123, a channel layer 125, and a resistance change layer 129 which are sequentially arranged inward in a direction (i.e., the x-axis direction in FIG. 2) from the outermost layer OL toward a center of the cell string CS. The x-axis direction may refer to a radial direction of the cell string CS. Each of the gate insulating layer 123, the channel layer 125, and the resistance change layer 129 may be provided to extend perpendicularly to the substrate 101 and may be shared by the plurality of memory cells MC. A source (S in FIG. 4) and a drain (D in FIG. 4) are provided at a lower end and an upper end of the channel layer 125, respectively, and the source and the drain may be connected to a common source line and a bit line, respectively, as described later. In the present disclosure, the term "outermost layer" refers to the position of the outermost layer OL relative to other inner layers, such as the insulating layer 123, the channel layer 125, and the resistance change layer 129. In one or more embodiments, an additional outer layer may be added, which make the outermost layer OL a relatively inner layer.

The gate electrode 121 controls a corresponding channel layer 125, and a word line may be electrically connected to the gate electrode 121. A voltage that turns on/off the corresponding channel layer 120 may be selectively applied to the gate electrode 121.

The gate electrode 121 may include, for example, a metal material having excellent electrical conductivity such as gold (Au), metal nitride, silicon doped with impurities, or a two-dimensional conductive material. However, this is merely an example, and the gate electrode 121 may include various other materials. Interlayer insulating layers 115 may be provided between the gate electrodes 121, and the interlayer insulating layer 115 may act as a spacer layer for insulation between the gate electrodes 121. The interlayer insulating layer 115 may include, for example, silicon oxide, silicon nitride, but is not limited thereto.

Channel holes are formed to penetrate the interlayer insulating layers 115 and the gate electrodes 121 in the axial direction. For example, these channel holes may be formed to have a circular cross-section. The gate insulating layer 123, the channel layer 125, and the resistance change layer 129 are sequentially provided on inner walls of the channel hole in the radial direction. Here, each of the gate insulating layer 123, the channel layer 125, and the resistance change layer 129 may be formed to have a cylindrical shape extending in the direction perpendicular to the substrate 101. A filling insulating layer 130 may be provided inward relative to the resistance change layer 129 to fill the channel hole. The filling insulating layer 130 may include, for example, silicon oxide or air, but is not limited thereto.

The channel layer 125 may include a semiconductor material. The channel layer 125 may include, for example, Si, Ge, SiGe, or Group III-V semiconductors. As an example, the channel layer 125 may include poly-Si, but is not limited thereto. The channel layer 125 may include, for example, an oxide semiconductor, a nitride semiconductor, an oxynitride semiconductor, a two-dimensional (2D) semiconductor material, quantum dots, or an organic semiconductor. Here, the oxide semiconductor may include, for example, InGaZnO, etc., the 2D semiconductor material may include, for example, transition metal dichalcogenide (TMD) or graphene, and the quantum dots may include colloidal quantum dots (colloidal QDs), a nanocrystal structure, etc. However, this is merely an example, and the present embodiment is not limited thereto.

The channel layer 125 may further include a dopant. Here, the dopant may include a p-type dopant or an n-type dopant. The p-type dopant may include, for example, a Group III element such as boron (B), aluminum (Al), gallium (Ga), indium (In), and the n-type dopant may include, for example, a Group V element such as phosphorus (P), argon (As), antimony (Sb).

The gate insulating layer 123 is provided between the gate electrode 121 and the channel layer 125. The gate insulating layer 123 may include various types of insulating materials. For example, silicon oxide, silicon nitride, or silicon oxynitride may be used in the gate insulating layer 123.

The resistance change layer 129 is provided inward relative to the channel layer 125. The resistance change layer 129 may include a material having resistance characteristics that change depending on an applied voltage. The resistance change layer 129 may include metal nitride or metal oxynitride. Here, the metal may include a transition metal. For example, the transition metal may include tantalum (Ta), titanium (Ti), molybdenum (Mo), vanadium (V), zinc (Zn), etc. But this is merely an example. Additionally, the metal may include Al or Ga. As an example, the resistance change layer 129 may include a metal nitride such as tantalum nitride (TaN) or a metal oxynitride such as tantalum oxynitride (TaON).

The ratio of nitrogen content to the sum of nitrogen content and oxygen content (i.e., nitrogen content + oxygen content) in the resistance change layer 129 may be approximately 0.01 or more to about 1 or less. Here, the content refers to atomic percent, which is the same hereinafter. When the resistance change layer 129 includes metal nitride, the ratio of nitrogen content to the sum of nitrogen content and oxygen content may be 1. When the resistance change layer 129 includes metal oxynitride, the ratio of nitrogen content to the sum of nitrogen content and oxygen content may be approximately 0.01 or less to less than about 1. For example, when the resistance change layer 129 includes metal oxynitride, the ratio of nitrogen content to the sum of nitrogen content and oxygen content may be approximately 0.1 or more to approximately 0.9 or less.

When the resistance change layer 129 includes metal nitride, the resistance characteristics of the resistance change layer 129 are determined by whether a conductive filament is formed due to the behavior of nitrogen that occurs within the resistance change layer 129 according to an applied voltage. In detail, when a certain voltage is applied to the resistance change layer 129, nitrogen vacancies V_{N} are formed within the resistance change layer 129, and the nitrogen vacancies V_{N} formed thus are gathered to form a conductive filament. Nitrogen ions located in the nitrogen vacancies V_{N} move to the channel layer 125 by diffusion. By forming the conductive filament, the resistance of the resistance change layer 129 is reduced. That is, the resistance change layer 129 changes from a high resistance state (HRS) to a low resistance state (LRS). The HRS may be defined as having a resistance greater than a first predetermined value (e.g., 1 megaohm (MΩ)) and the LRS may defined as having a resistance less than a second predetermined value (e.g., 100 kiloohms (kΩ)). When the resistance change layer 129 includes metal oxynitride, a conductive filament may be formed by nitrogen vacancies and oxygen vacancies.

The resistance change layer 129 may have a low-resistance state or a high-resistance state according to whether a conductive filament is formed, and may record information of '1' or '0', accordingly. The applied voltage that changes the resistance change layer 129 from a high-resistance state to a low-resistance state is called a set voltage V_{SET}, and the applied voltage that changes a low-resistance state to a high-resistance state is called a reset voltage V_{RESET}.

The operation of the variable resistance memory device 100 described above will be described with reference to FIG. 4 as follows. FIG. 4 is an enlarged view of portion B of FIG. 2.

Referring to FIG. 4, when a memory cell MC2 to be written is selected, a gate voltage value of the memory cell MC2 is adjusted such that a channel is not formed in the selected memory cell MC2, that is, the channel is turned off, and gate voltage values of memory cells MC1 and MC3 that are not selected are adjusted such that the channels of the unselected memory cells MC1 and MC3 are turned on.

In FIG. 4, a gate voltage is applied to a gate electrode of each of the memory cells MC1, MC2, and MC3 such that the memory cell MC2 in the middle is turned off and the two memory cells MC1 and MC3 below and above the memory cell MC2 are turned on. When a voltage is applied between a source S and a drain D, a conduction path as shown by an arrow H is formed. Here, desired information of 1 or 0 may be written into the selected memory cell MC2 by setting the applied voltage between the source S and the drain D as a set voltage V_{SET} or a reset voltage V_{RESET}.

In a read operation, similarly, reading of the selected memory cell MC2 may be performed. That is, after a gate voltage applied to each gate electrode 121 is adjusted such that the selected memory cell MC2 is in a channel-off state and the unselected memory cells MC1, MC3 are in a channel-on state, the state (1 or 0) of the memory cell MC2 may be identified by measuring current flowing in the memory cell MC2 by an applied voltage V_{read} between the source S and the drain D.

In variable resistance memory devices according to the related art, oxides such as HfO₂ may be used as a resistance change layer, but in this case, the content of oxygen vacancies in a thin film implemented by atomic layer deposition (ALD) is low and thus it may be difficult to form a conductive filament, which may result in poor resistance change characteristics.

In the variable resistance memory device 100 according to the present embodiment, by using metal nitride or metal oxynitride as a resistance change layer, a conductive filament may be easily formed by nitrogen vacancies, and thus the resistance change characteristics may be improved to reduce the operating voltage, and the yield may also be increased.

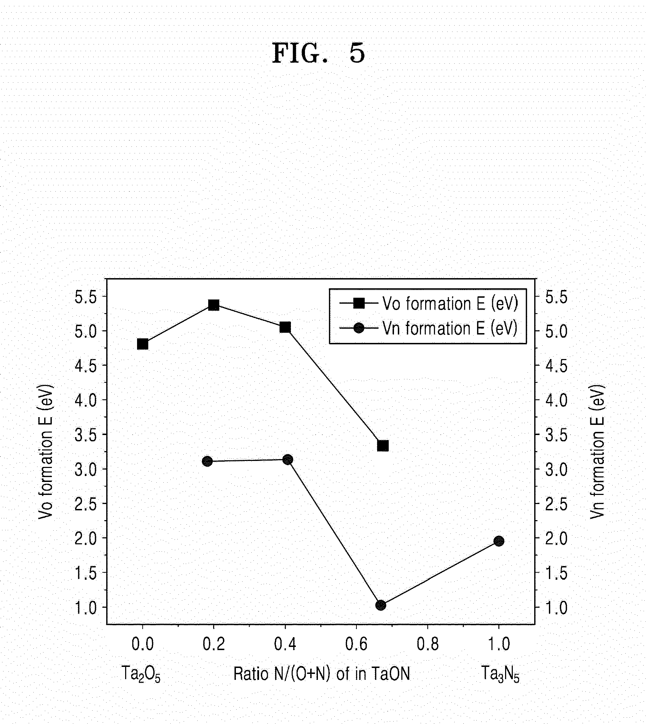

[Table 1] below shows a band gap (Eg), oxygen vacancy (Vo) formation energy, and nitrogen vacancy (Vn) formation energy for tantalum oxide (TaO), TaON, and TaN resistance change layers. FIG. 5 shows simulation results obtained using Discrete Fourier Transform (DFT) with regard to oxygen vacancy (Vo) formation energy and nitrogen vacancy (Vn) formation energy for TaO, TaON, and TaN resistance change layers. In [Table 1] and FIG. 5, "N/(O+N)" refers to the ratio of nitrogen content to the sum of oxygen content and nitrogen content, and the same applies hereinafter.

**[Table 1]**

| Composition | **TaO** | **TaON** | | | **TaN** |
|---|---|---|---|---|---|
| N/(O+N) | 0 | 0.18 | 0.4 | 0.67 | 1.0 |
| Eg (eV) | 4.20 | 3.17 | 2.75 | 2.34 | 2.04 |
| Vo formation Energy (eV) | 4.83 | 5.40 | 5.09 | 3.35 | |
| Vn formation Energy (eV) | | 3.12 | 3.16 | 1.05 | 1.97 |

Referring to [Table 1] and FIG. 5, it can be seen that the oxygen vacancy (Vo) formation energy for the TaO resistance change layer is greater than the nitrogen vacancy (Vn) formation energy for the TaN resistance change layer. In addition, it can be seen that as N/(O+N) increases in the TaON resistance change layer, the nitrogen vacancy (Vn) formation energy decreases. As described above, it is easier to form nitrogen vacancies (Vn) than oxygen vacancies (Vo), and thus, the TaN resistance change layer changes from a high resistance state (HRS) to a low resistance state (LRS) at a lower voltage than the TaO resistance change layer, and the yield may also be increased.

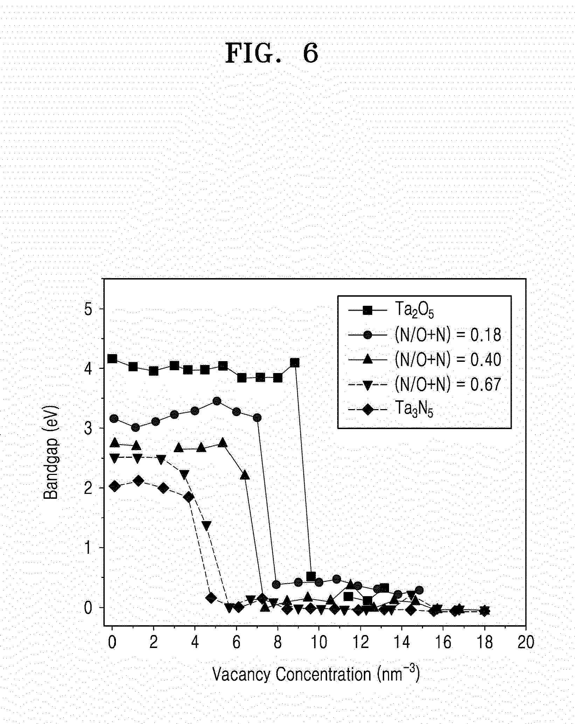

FIG. 6 shows simulation results obtained using DFT with regard to a band gap according to a vacancy concentration for TaO, TaON, and TaN resistance change layers.

Referring to FIG. 6, a conductive filament may be formed with a lower vacancy concentration in a TaN resistance change layer or a TaON resistance change layer with a large nitrogen content. As vacancies are formed in the resistance change layer, the band gap (Eg) decreases due to an increase in traps due to dangling bonds. As illustrated in FIG. 6, a low-resistance state (i.e., Eg = 0) may be reached with a smaller vacancy concentration in a TaN resistance change layer or a TaON resistance change layer with a large nitrogen content, thereby lowering the operating voltage of a device. Additionally, because the conductive filament is not excessively thick due to the low vacancy concentration, a reset operation may be easy and endurance of the device may be improved.

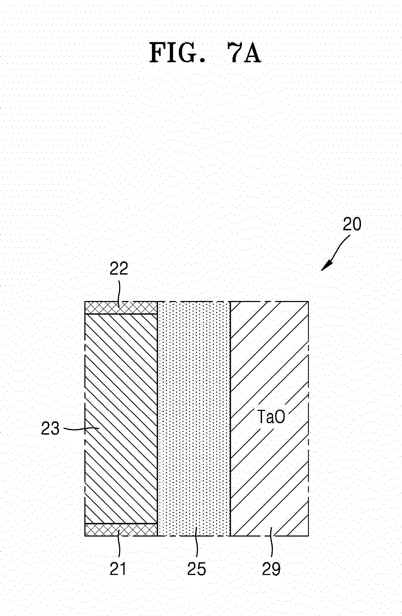

FIG. 7A shows a structure of a variable resistance memory device according to a comparative example. Referring to FIG. 7A, a lower electrode 21 and an upper electrode 22 are provided on one side of the channel layer 25, and an insulating layer 23 is provided between the lower electrode 21 and the upper electrode 22. And, a TaO resistance change layer 29 is provided on the other side of the channel layer 25.

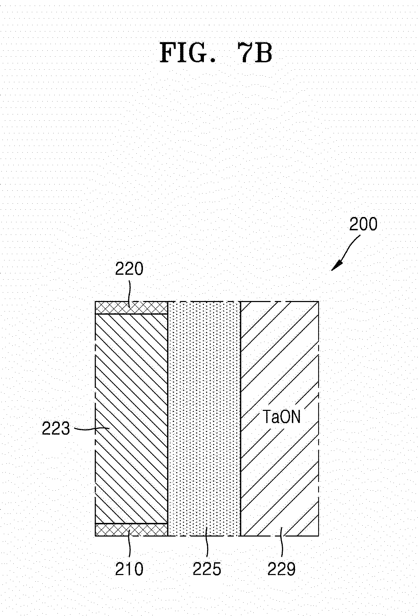

FIG. 7B shows a structure of a variable resistance memory device 200 according to one or more embodiments. Referring to FIG. 7B, a lower electrode 210 and an upper electrode 220 are provided on one side of the channel layer 225, and an insulating layer 223 is provided between the lower electrode 210 and the upper electrode 220. Additionally, a TaON resistance change layer 229 is provided on the other side of the channel layer 225.

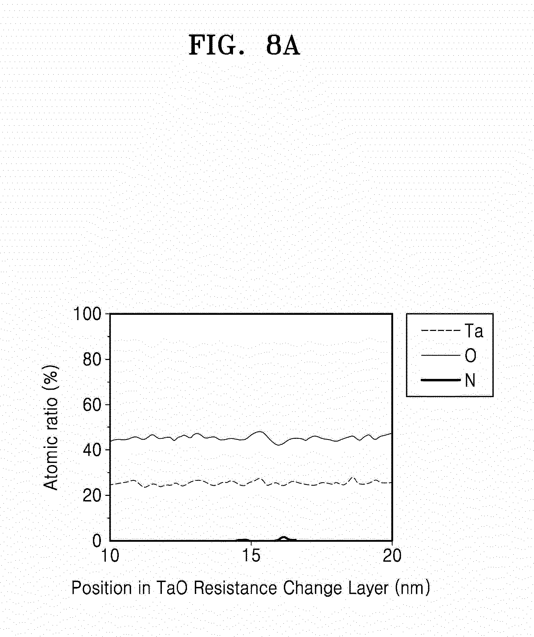

FIG. 8A shows results of measuring the TaO resistance change layer 29 illustrated in FIG. 7A using Transmission Electron Microscopy with Energy-Dispersive X-ray Spectroscopy (TEM EDS). Referring to FIG. 8A, the TaO resistance change layer 29 was found to be a TaO thin film having a nitrogen content of 0 atomic percent (at%).

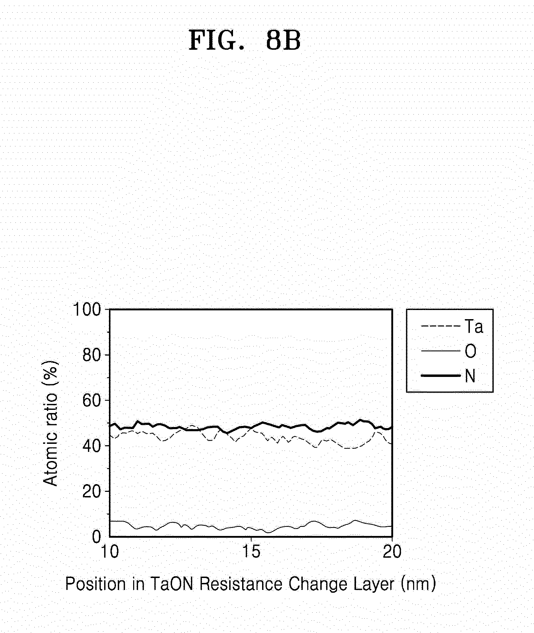

FIG. 8B shows results of measuring the TaON resistance change layer 229 illustrated in FIG. 7B using TEM EDS. Referring to FIG. 8B, the TaON resistance change layer 229 was found to be a TaON thin film having N/(O+N) of 0.9.

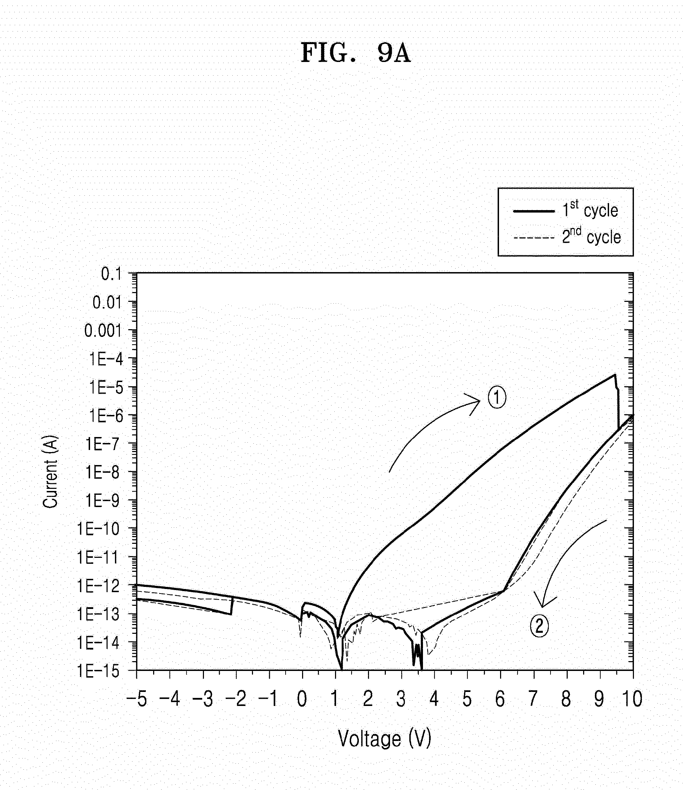

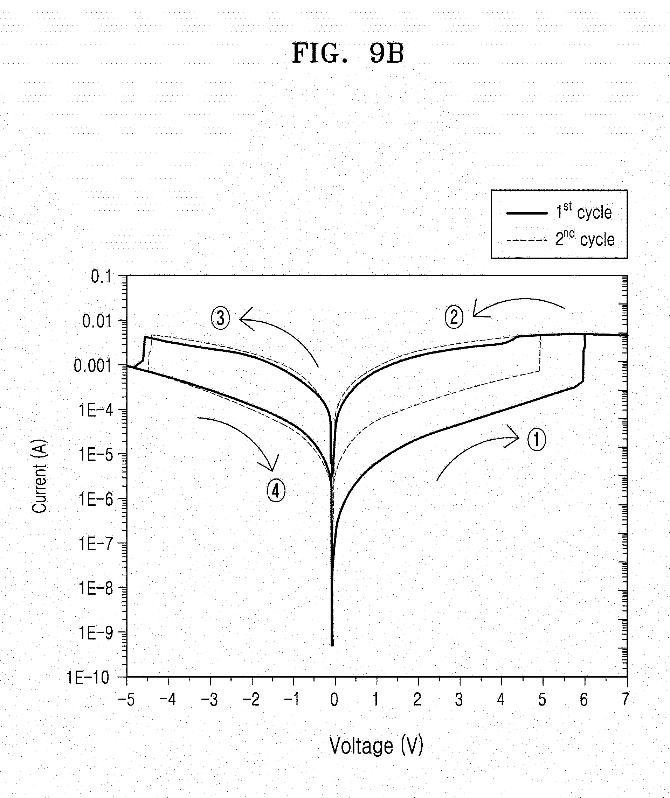

FIG. 9A shows I-V characteristics of the variable resistance memory device 20 according to the comparative example illustrated in FIG. 7A. FIG. 9B shows I-V characteristics of the variable resistance memory device 200 according to the embodiment illustrated in FIG. 7B.

As illustrated in FIG. 9A, the TaO resistance change layer 29 did not show resistance change characteristics from a high resistance state (HRS) to a low resistance state (LRS) even when a voltage of +10 V was applied. Rather, the high voltage caused thin film separation in the resistance change layer, preventing current from flowing. However, as illustrated in FIG. 9B, a set operation was performed in the TaON resistance change layer 229 having a large nitrogen content when a voltage of approximately +6 V was applied. This is due to the easier nitrogen vacancy formation than oxygen vacancy formation and the operating voltage reduced by formation of a conductive filament with a lower concentration of nitrogen vacancies. Referring to FIG. 9B, a reset operation that changes from a low resistance state (LRS) to a high resistance state (HRS) again at a voltage of -4.5 V was performed. Additionally, a set/reset operation was found in a second cycle. As a result of experiments on 36 devices, a set operation was found in 81 % of the devices in the TaON resistance change layer with N/(O+N) of 0.9 in a first cycle, and a set operation was found in 33% of the devices in the TaON resistance change layer with N/(O+N) of 0.9 in the second cycle. In contrast, there was no switching in in the TaO resistance change layer the first and second cycles. Therefore, it can be seen that the TaON resistance change layer has a higher switching yield than the TaO resistance change layer.

As described above, in the variable resistance memory device 100 according to the embodiment, by forming the resistance change layer 129 by using metal nitride or metal oxynitride, a conductive filament with a lower vacancy concentration may be formed, and the operating voltage may be reduced, accordingly. Also, because the conductive filament does not become excessively thick due to the low vacancy concentration, a reset operation may be easy and endurance of the variable resistance memory device 100 may be improved.

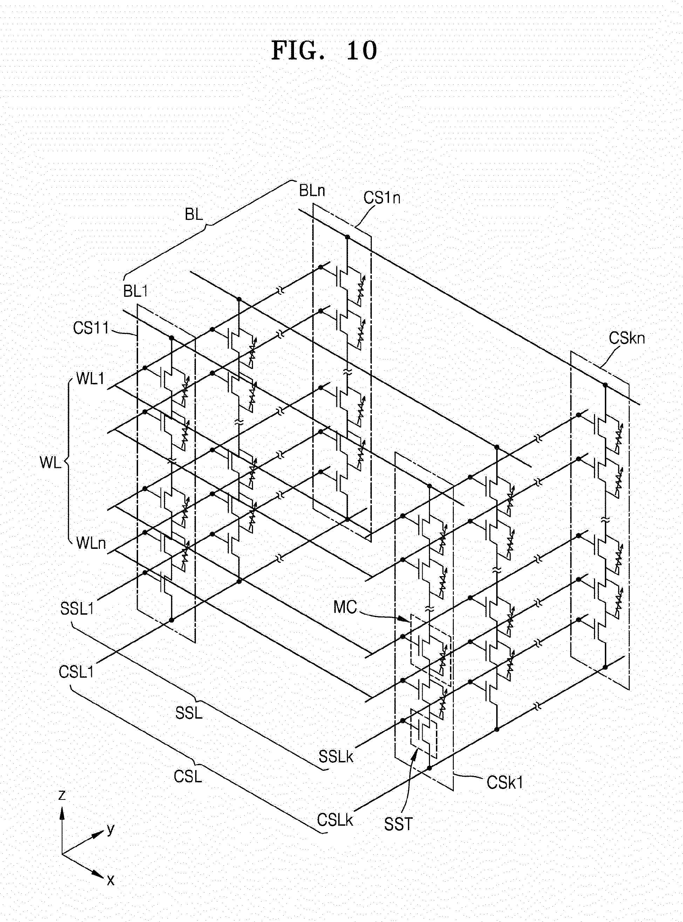

FIG. 10 illustrates an example of an equivalent circuit diagram of the variable resistance memory device 100 according to the embodiment illustrated in FIG. 1.

Referring to FIG. 10, k*n cell strings CS may be provided and arranged in a matrix form, and referred to as CSij (1≤i≤k, 1≤j≤n) according to the position of each row and column. Each cell string CSij is connected to a bit line BL, a string select line SSL, a word line WL, and a common source line CSL. Each cell string CSij includes memory cells MC and a string select transistor SST. The memory cells MC and the string select transistor SST of each cell string CSij may be stacked in a height direction.

Rows of the plurality of cell strings CS are respectively connected to different string select lines SSL1 to SSLk. For example, the string select transistors SST of cell strings CS11 to CS1n are commonly connected to a string select line SSL1. The string select transistors SST of the cell strings CSk1 to CSkn are commonly connected to the string select line SSLk. Columns of the plurality of cell strings CS are respectively connected to different bit lines BL1 to BLn. For example, the memory cells MC and string select transistors SST of the cell strings CS11 to CSk1 may be commonly connected to the bit line BL1, and the memory cells MC and the string select transistors SST of the cell strings CS1n to CSkn may be commonly connected to the bit line BLn.

The rows of the plurality of cell strings CS may be respectively connected to different common source lines CSL1 to CSLk. For example, the string select transistors SST of the cell strings CS11 to CS1n may be commonly connected to the common source line CSL1, and the string select transistors SST of the cell strings CSk1 to CSkn may be commonly connected to the common source line CSLk. The gate electrodes 121 of the memory cells MC located at the same height from the substrate 101 or the string select transistors SST may be commonly connected to one word line WL, and the gate electrodes 121 of the memory cells MC located at different heights from each other may be respectively connected to different word lines WL1 to WLm.

The circuit structure illustrated in FIG. 10 is provided as an example, and embodiments of the present disclosure are not limited thereto. For example, the number of rows of the cell strings CS may be increased or decreased. As the number of rows of the cell string CS changes, the number of string select lines connected to the rows of the cell string CS and the number of cell strings CS connected to one bit line may also change. As the number of rows of the cell strings CS changes, the number of common source lines connected to the rows of the cell strings CS may also change. The number of columns of the cell strings CS may also be increased or decreased. As the number of columns of the cell strings CS changes, the number of bit lines connected to the columns of the cell strings CS and the number of the cell strings CS connected to one string select line may also change.

The height of the cell strings CS may also be increased or decreased. For example, the number of the memory cells MC stacked in each cell string CS may be increased or decreased. As the number of the memory cells MC stacked in each cell string CS changes, the number of word lines WL may also change. For example, the string select transistor provided to each of the cell strings CS may be increased. As the number of string select transistors provided to each of the cell strings CS changes, the number of string select lines or common source lines may also change. As the number of string select transistors increases, the string select transistors may be stacked in the same form as the memory cells MC.

For example, writing and reading may be performed in units of rows of cell strings CS. The cell strings CS may be selected in units of one row by the common source line CSL, and the cell strings CS may be selected in units of one row by the string select lines SSL. Additionally, a voltage may be applied to the common source lines CSL as a unit of at least two common source lines. Voltage may be applied to the common source lines CSL as a single unit.

In a selected row of cell strings CS, writing and reading may be performed in units of pages. A page may be one row of memory cells connected to one word line WL. In the selected row of cell strings CS, memory cells may be selected in units of pages by word lines WL.

The memory cell MC has a circuit structure in which a transistor including the gate electrode 121, the gate insulating layer 123, and the channel layer 125 and a variable resistor formed by the resistance change layer 129 are connected to each other in parallel to each other. The parallel connection structure is continuously arranged in a vertical direction (the z-axis direction) to form a cell string CS. Additionally, a common source line CSL and a bit line BL may be connected to both ends of the cell string CS. By applying a voltage to the common source line CSL and the bit line BL, program, read, and erase processes may be performed on the plurality of memory cells MC.

For example, when a memory cell MC to be written is selected, a gate voltage value of the corresponding memory cell MC is adjusted such that a channel is not formed in the selected memory cell MC, that is, the channel is turned off, and gate voltage values of unselected memory cells MC are adjusted such that channels of the unselected memory cells MC are turned on. Accordingly, a current path by a voltage applied to the common source line CSL and the bit line BL passes through the resistance change layer 129 of the selected memory cell MC, and here, the applied voltage may be set to a set voltage V_{SET} or a reset voltage V_{RESET} so as to form a low-resistance state or a high-resistance state, and desired information of 1 or 0 may be recorded in the selected memory cell MC.

In a read operation, similarly, reading of a selected cell may be performed. That is, after a gate voltage applied to each gate electrode 121 is adjusted such that the selected memory cell MC is in a channel-off state and the unselected memory cells MC are in a channel-on state, the state of a corresponding memory cell MC (1 or 0) may be identified by measuring current flowing in the corresponding memory cell MC by the applied voltage V_{read} between the common source line CSL and the bit line BL.

The variable resistance memory device 100 being a vertical NAND flash memory device in which the memory cells MC are arranged in the direction perpendicular to the substrate 101 along the cell strings CS is described above. However, the disclosure is not limited thereto, and as will be described later, a variable resistance memory device in which memory cells are arranged in a direction parallel to a substrate may also be implemented.

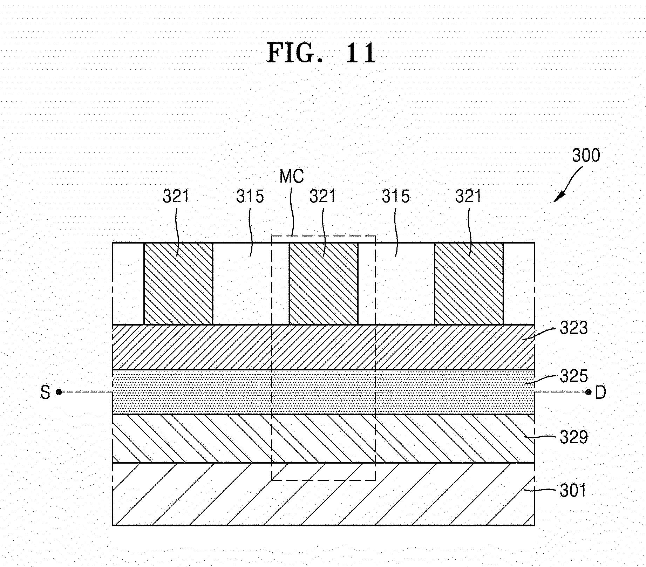

FIG. 11 illustrates a variable resistance memory device 300 according to another embodiment. Hereinafter, the description will focus on differences from the embodiment described above.

Referring to FIG. 11, a plurality of memory cells MC are arranged in a direction parallel to a substrate 301. A resistance change layer 329, a channel layer 325, and a gate insulating layer 323 may be sequentially stacked on the substrate 301 in a direction perpendicular to the substrate 301. On the gate insulating layer 323, a plurality of gate electrodes 321 are arranged apart from each other in a direction parallel to the substrate 301, and interlayer insulating layers 315 are provided between the gate electrodes 321, respectively.

A voltage that turns on/off a corresponding channel layer 325 may be selectively applied to the gate electrode 321. The channel layer 325 may include a semiconductor material. The channel layer 325 may further include a dopant. Both ends of the channel layer 325 may be connected to the source S and the drain D, respectively.

The resistance change layer 329 may include a material having resistance characteristics that change according to an applied voltage. The resistance change layer 329 may include metal nitride or metal oxynitride. Here, the metal may include a transition metal. For example, the transition metal may include Ta, Ti, Mo, V, Zn, etc. But this is merely an example. Additionally, the metal may include Al or Ga. As an example, the resistance change layer 329 may include a metal nitride such as TaN or a metal oxynitride such as TaON.

The ratio of nitrogen content to the sum of nitrogen content and oxygen content in the resistance change layer 329 may be approximately 0.01 or more to about 1 or less. Here, the content refers to atomic percent, which is the same hereinafter. When the resistance change layer 329 includes metal nitride, the ratio of nitrogen content to the sum of nitrogen content and oxygen content may be 1. When the resistance change layer 329 includes metal oxynitride, the ratio of nitrogen content to the sum of nitrogen content and oxygen content may be approximately 0.01 or less to less than approximately 1. For example, when the resistance change layer 329 includes metal oxynitride, the ratio of nitrogen content to the sum of nitrogen content and oxygen content may be approximately 0.1 or more to approximately 0.9 or less.

In a variable resistance memory device according to the present embodiment, by using metal nitride or metal oxynitride as a resistance change layer, a conductive filament may be easily formed by nitrogen vacancies, and thus the operating voltage may be reduced and the yield may be improved.

The variable resistance memory devices 100 and 300 according to the embodiments described above may be employed as a memory system of various electronic apparatuses. The variable resistance memory devices 100 and 300 may be implemented as chip-shaped memory blocks and used as a neuromorphic computing platform, or may be used to configure a neural network.

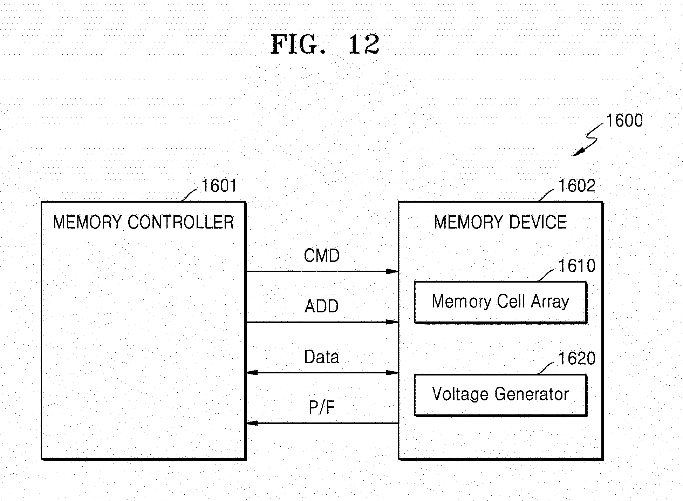

FIG. 12 is a block diagram of a memory system 1600 according to one or more embodiments.

Referring to FIG. 12, the memory system 1600 may include a memory controller 1601 and a memory device 1602. The memory controller 1601 performs a control operation on the memory device 1602, and for example, the memory controller 1601 may provide an address ADD to the memory device 1602 and a command CMD to perform a programming (or recording), reading and/or erasing operation on the memory device 1602. Additionally, data for a programming operation and read data may be transmitted between the memory controller 1601 and the memory device 1602.

The memory device 1602 may include a memory cell array 1610 and a voltage generator 1620. The memory cell array 1610 may include a plurality of memory cells arranged in an area where a plurality of word lines and a plurality of bit lines intersect with each other. The memory cell array 1610 may include the variable resistance memory devices 100 and 300 according to the embodiments described above.

The memory controller 1601 may include a processing circuitry, such as hardware, including logic circuits; hardware/software combinations, such as processor executing software; or a combination thereof. Examples of the processing circuitry may include a central processing unit (CPU), an arithmetic logic unit (ALU), a digital signal processor, a microcomputer, a field programmable gate array (FPGA), a system-on-chip (SoC), a programmable logic, a microprocessor, an application-specific integrated circuit (ASIC), etc., but are not limited thereto. The memory controller 1601 may operate in response to a request from a host and may be configured to access the memory device 1602 and control the control operations described above (e.g., write/read operations) so as to convert the memory controller 1601 to a special purpose controller. The memory controller 1601 may generate an address ADD and a command CMD to perform programming/read/erase operations on the memory cell array 1610. Additionally, in response to a command from the memory controller 1601, the voltage generator 1620 (e.g., a power circuit) may generate a voltage control signal for controlling a voltage level of a word line, for programming or reading data on or from the memory cell array 1610.

Additionally, the memory controller 1601 may perform a decision operation on data read from the memory device 1602. For example, from data read from a memory cell, the number of on-cells and/or the number of off-cells may be determined. The memory device 1602 may provide a pass/fail signal P/F to the memory controller 1601 according to a reading result of the read data. The memory controller 1601 may control write and read operations of the memory cell array 1610 by referring to the pass/fail signal P/F.

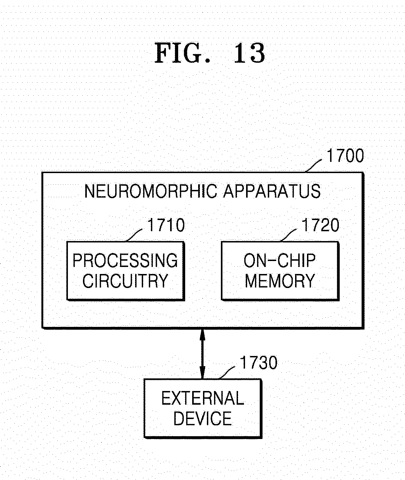

FIG. 13 is a block diagram illustrating a neuromorphic apparatus 1700 and an external device connected thereto, according to one or more embodiments.

Referring to FIG. 13, the neuromorphic apparatus 1700 may include a processing circuitry 1710 and/or an on-chip memory 1720. The neuromorphic apparatus 1700 may include the variable resistance memory devices 100 and 300 according to the embodiments described above.

In some embodiments, the processing circuitry 1710 may be configured to control functions for driving the neuromorphic apparatus 1700. For example, the processing circuitry 1710 may be configured to control the neuromorphic apparatus 1700 by executing a program stored in the on-chip memory 1720. In some embodiments, the processing circuitry may include hardware such as logic circuitry, a hardware/software combination such as a processor executing software, or a combination thereof. For example, the processor may include a CPU, a graphics processing unit (GPU), an application processor (AP) included in the neuromorphic apparatus 1700, an ALU, a digital signal processor, a microcomputer, a FPGA, a SoC, a programmable logic unit, a microprocessor, ASIC, but is not limited thereto. In some embodiments, the processing circuitry 1710 may be configured to read/write various data from or to the external device 1730 and/or execute the neuromorphic apparatus 1700 by using the read/written data. In some embodiments, the external device 1730 may include an external memory and/or a sensor array with an image sensor (e.g., a complementary metal oxide semiconductor (CMOS) image sensor circuit).

In some embodiments, the neuromorphic apparatus 1700 of FIG. 13 may be applied to a machine learning system. As a machine learning system, various artificial neural network systems and processing models such as a convolutional neural network (CNN), a deconvolutional neural network, a recurrent neural network (RNN) (optionally including a long short-term memory (LSTM) unit and/or a gated recurrent unit (GRU)), a stacked neural network (SNN), a state-space dynamic neural network (SSDNN), a deep belief network (DBN), a generative adversarial network (GAN), and/or a restricted Boltzmann machine (RBM) may be used.

Alternatively or additionally, these machine learning systems may be implemented with other forms of machine learning models, such as linear and/or logistic regression, statistical clustering, Bayesian classification, decision trees, dimensionality reduction such as principal component analysis, expert systems, and/or an ensemble such as random forests or a combination thereof. These machine learning models may be used to provide a variety of services and/or applications, and for example, image classification services, user authentication services based on biometric information or biometric data, advanced driver assistance system (ADAS) services, voice assistant services, automatic speech recognition (ASR) services, etc. may be executed by an electronic apparatus.

According to the above embodiments, by forming a resistance change layer by using metal nitride or metal oxynitride, a conductive filament may be formed with a lower vacancy concentration and thus the operating voltage may be lowered. Additionally, because the conductive filament is not excessively thick due to the low vacancy concentration, a reset operation may be easy and endurance of the memory device may be improved. The variable resistance memory devices 100 and 300 are described above according to the embodiments illustrated in the drawings. However, the descriptions are only examples, and one of ordinary skill in the art may understand that various modifications and equivalent embodiments are possible from the descriptions.

The foregoing exemplary embodiments are merely exemplary and are not to be construed as limiting. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A variable resistance memory device comprising:
a resistance change layer having resistance characteristics that change according to a voltage applied to the resistance change layer;
a channel layer provided on the resistance change layer; and
a gate electrode provided on the channel layer,
wherein the resistance change layer comprises metal nitride or metal oxynitride.

2. The variable resistance memory device of claim 1, wherein a ratio of nitrogen content to a sum of nitrogen content and oxygen content in the resistance change layer is in a range from 0.01 to 1.

3. The variable resistance memory device of claim 2, wherein the ratio of nitrogen content to the sum of nitrogen content and oxygen content in the resistance change layer is less than or equal to 0.9.

4. The variable resistance memory device of any preceding claim, wherein the resistance change layer comprises tantalum nitride (TaN) or tantalum oxynitride (TaON).

5. The variable resistance memory device of any preceding claim, wherein the metal comprises a transition metal, aluminum (Al), or gallium (Ga).

6. The variable resistance memory device of any preceding claim, wherein the channel layer comprises silicon (Si), germanium (Ge), silicon germanium (SiGe), a Group III-V semiconductor, an oxide semiconductor, a nitride semiconductor, an oxynitride semiconductor, a two-dimensional semiconductor material, quantum dots, or an organic semiconductor.

7. The variable resistance memory device of any preceding claim, wherein the gate electrode comprises a metal material, metal nitride, silicon doped with impurities, or a two-dimensional conductive material.

8. The variable resistance memory device of any preceding claim, further comprising a gate insulating layer provided between the gate electrode and the channel layer.

9. The variable resistance memory device of claim 8, wherein the gate insulating layer comprises silicon oxide, silicon nitride, or silicon oxynitride.

10. The variable resistance memory device of any preceding claim further comprising:
a plurality of cell strings, each of the plurality of cell strings extending vertically on a substrate,
provided inward relative to the channel layer, the; and
a plurality of gate electrodes provided outward relative to the channel layer,

11. The variable resistance memory device of claim 10, wherein a channel hole extending in a direction perpendicular to the substrate is formed inward relative to the channel layer.

12. The variable resistance memory device of claim 11, wherein the channel layer and the resistance change layer are each formed in a cylindrical shape surrounding the channel hole.

13. The variable resistance memory device of claim 12, wherein the plurality of gate electrodes are arranged apart from each other in a direction perpendicular to the substrate, and the plurality of gate electrodes surround the channel layer.

14. The variable resistance memory device of claim 13, further comprising an interlayer insulating layer provided between the plurality of gate electrodes.

15. The variable resistance memory device of claim 13, further including a gate insulating layer provided between the plurality of gate electrodes and the channel layer.
